# EUROPEAN PATENT SPECIFICATION

(11) **EP 1 808 944 B1**
(45) Date of publication and mention of the grant of the patent: **18.03.2015**
(21) Application number: 07000562.4
(22) Date of filing: 12.01.2007
(51) Int. Cl.: H01S 5/183, H01S 5/024

(54) **Surface-emitting type semiconductor laser**
Oberflächenemittierender Halbleiterlaser
Laser semiconducteur à émission par la surface

(30) Priority: 12.01.2006 JP 2006005323
(43) Date of publication of application: 18.07.2007
(73) Proprietor: Seiko Epson Corporation, Shinjuku-ku, Tokyo 163-0811 (JP)
(72) Inventor: Mochizuki, Masamitsu, Nagano-ken 392-8502 (JP)
(74) Representative: MERH-IP Matias Erny Reichl Hoffmann

(56) References cited:
- EP-A2- 0 653 823
- WO-A-98/57402
- WO-A-02/073753
- US-A1- 2001 011 730
- US-A1- 2004 091 010
- US-B1- 6 396 864
- US-B1- 6 751 245
- WIPIEJEWSKI T ET AL: "Improved performance of vertical-cavity surface-emitting laser diodes with Au-plated heat spreading layer" ELECTRONICS LETTERS, IEE STEVENAGE, GB, vol. 31, no. 4, 16 February 1995 (1995-02-16), pages 279-281, XP006002449 ISSN: 0013-5194

## Description

The present invention relates to surface-emitting type semiconductor lasers (hereinafter referred to as "SES lasers").

In response to a substantial increase in data amount and an increasing range of applications of SES lasers in recent years, it is desired to reduce the number of oscillation modes while maintaining a high power output. In general, the number of oscillation modes is reduced by reducing the volume of each resonator.

It is noted that the output of a semiconductor laser increases with an increase in , and reaches a maximum value (i.e., a rolloff point) at a certain current value. This is because, in a semiconductor laser, its gain spectrum shifts with an increase in the device temperature caused by injection of current, and the gain reaches a maximum value at a certain temperature. When the volume of a resonator is relatively small, the temperature of the device would readily increase, and its rolloff point is reached at a relatively low current value, such that a sufficient output or current driving range may not be obtained. When a sufficient output cannot be obtained, the driving point and the rolloff point come closer to each other, and the fluctuation in the output caused by the surrounding temperature may become greater unless the driving current range is narrowed, i.e. the extinction ratio becomes as small and the bit error rate becomes large. In this connection, to prevent an increase in the device temperature, JP-A-2003-86895 describes a method in which a groove reaching the current constricting section is formed around the light emitting section, and an electrode is directly formed over the groove. As a result, the distance between a heat generating section and the electrode is shortened, thereby improving the heat radiation efficiency.

A surface-emitting type semiconductor laser according to the pre-characterizing portion of claim 1 is known from WO 02/073753. In one embodiment disclosed in this document the whole structure from the substrate to the second mirror forms one columnar section with the second electrode provided in a ring shape on the uppermost surface of the structure. In another embodiment, one columnar section includes all of the structure from the substrate to the ring shaped second electrode but except for the second mirror. In this embodiment, the second mirror is formed with a smaller diameter than the remaining structure and is provided on top of the remaining structure with a lower part of the second mirror having a smaller diameter than the remaining part of the second mirror and filling the inside of the ring shape of the second electrode.

It is an object of the present invention to provide a surface-emitting type semiconductor (SES) laser in which the number of modes can be reduced and a high power output can be maintained.

This object is achieved by an SES laser as claimed in claim 1. Preferred embodiments of the invention are defined in the dependent claims.

Preferred embodiments of the invention are described below with reference to the accompanying drawings, in which:
- FIG. 1: is a schematic cross-sectional view of an SES laser in accordance with an embodiment of the invention;
- FIG. 2: is a schematic plan view of the SES laser in accordance with the embodiment of the invention;
- FIG. 3: is a view showing a step of a method for manufacturing an SES laser in accordance with an embodiment of the invention;
- FIG. 4: is a view showing a step of the method for manufacturing an SES laser in accordance with the embodiment of the invention;
- FIG. 5: is a view showing a step of the method for manufacturing an SES laser in accordance with the embodiment of the invention;
- FIG. 6: is a schematic cross-sectional view of an SES laser in accordance with a first modified example of the embodiment of the invention;
- FIG. 7: is a schematic cross-sectional view of an SES laser in accordance with a second modified example of the embodiment of the invention;
- FIG. 8: is a schematic cross-sectional view of an SES laser in accordance with a third modified example of the embodiment of the invention; and
- FIG. 9: is a schematic cross-sectional view of an SES laser in accordance with a fourth modified example of the embodiment of the invention.

Preferred embodiments of the invention are described below with reference to the accompanying drawings.

### 1. SES Laser

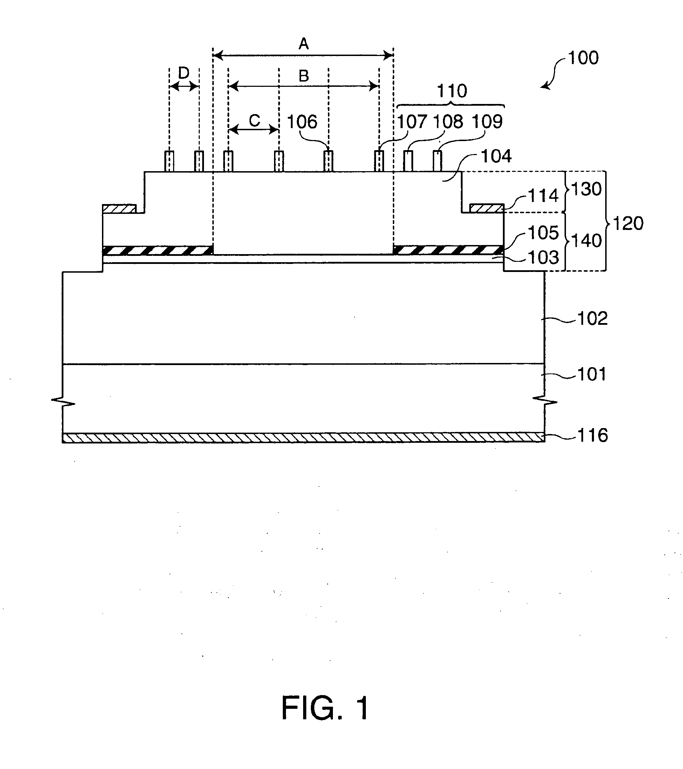

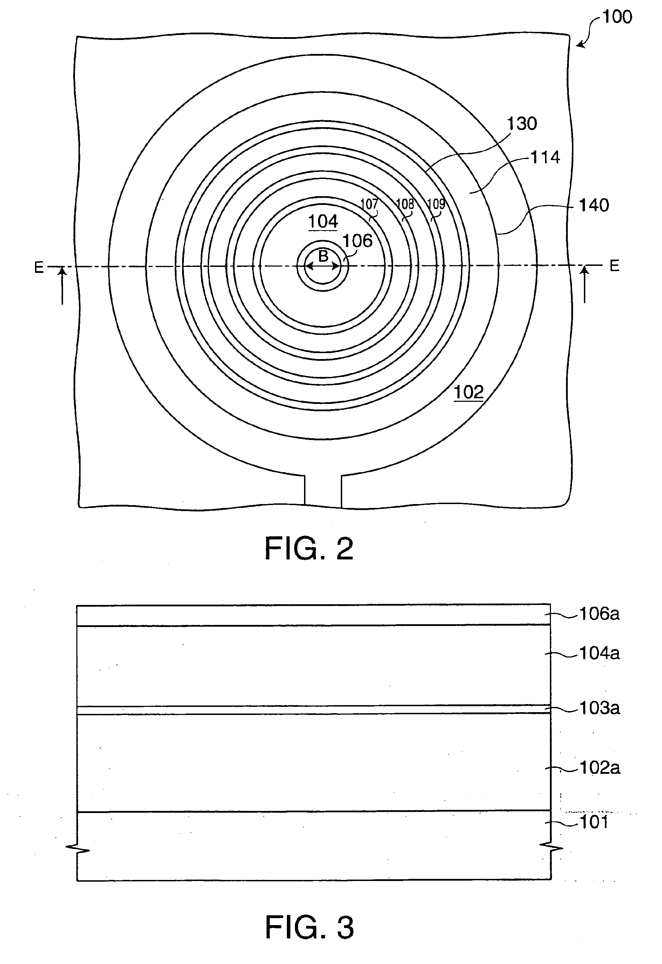

FIG. 1 is a schematic cross-sectional view of an SES laser 100 in accordance with an embodiment of the invention. FIG. 2 is a schematic plan view of the SES laser 100 in accordance with the embodiment. FIG. 1 is a cross-sectional view taken along a line E - E of FIG. 2.

The SES laser 100 includes a substrate 101, a first mirror 102, an active layer 103 and a second mirror 104. The SES laser 100 includes a vertical resonator, and may include a columnar semiconductor deposited body (hereafter referred to as a "columnar section") 120, as shown in FIG. 1. A first columnar section 120 is composed of a portion of the first mirror 102, the active layer 103 and the second mirror 104, and includes a second columnar section 130 provided in its upper portion, and a third columnar section 140 provided in its lower portion. The second columnar section 130 includes the second mirror 104, and the third columnar section 140 includes the first mirror 102, the active layer 103 and the second mirror 104. The second columnar section 130 is formed on an upper surface of the third columnar section 140, and has a diameter smaller than the diameter of the third columnar section 140, as viewed in a plan view.

The substrate 101 may be formed from a semiconductor substrate, for example, an n-type GaAs substrate. The first mirror 102 may be composed of, for example, a distributed reflection type multilayer mirror of 40 pairs of alternately laminated n-type Al_{0.9}Ga_{0.1}As layers and n-type Al_{0.15}Ga_{0.85}As layers. The active layer 103 may be composed of, for example, GaAs well layers and Al_{0.3}Ga_{0.7}As barrier layers in which the well layers include a quantum well structure composed of three layers. The second mirror 104 may be composed of, for example, a distributed reflection type multilayer mirror of 25 pairs of alternately laminated p-type Al_{0.9}Ga_{0.1}As layers and p-type Al_{0.15}Ga_{0.85}As layers.

The second mirror 104 may be made to be p-type by doping, for example, carbon (C), and the first mirror 102 may be made to be n-type by doping, for example, silicon (Si). Accordingly, the p-type second mirror 104, the active layer 103 that is not doped with any impurity, and the n-type first mirror 102 form a pin diode. It is noted that, in the present exemplary embodiment, the second columnar section 120 has a circular shape in a plan view, but may have any other arbitrary shape.

The second mirror 104 further includes a current constricting section 105 formed in a region near the active layer. The current constricting section 105 may be formed from an oxidized constricting section or a proton implanted region. The current constricting section 105 may be obtained by oxidizing, for example, an Al_{X}Ga_{1-X}As (x > 0.95) layer from its side surface, and may have a ring shape in a plan view.

The SES laser 100 includes a plurality of lattices or grids 106, 107, 108 and 109 on the second mirror 104, thereby forming a circular diffraction grating. Each of the lattices 106, 107, 108 and 109 that form the diffraction grating is arranged on the uppermost surface of the second mirror 104, i.e., in a plane perpendicular to a light emission direction of light emitted from the SES laser 100. The lattices 106, 107, 108 and 109 each have a ring shape, as shown in FIG. 2, and are formed on mutually concentric circles. Light is reflected inwardly in a region surrounded by the diffraction grating 110 (the lattices 107 - 109), thereby maintaining light confinement. This light confining region, in other words, an area inside the lattice 107, is formed inside a region surrounded by the current constricting section 105 as viewed in a plan view. In other words, the diameter B of the light confining region is smaller than the inner diameter A of the current constricting section 105.

A gap C between the lattice 106 and the lattice 107 formed radially outside the lattice 106 may be the same as the diameter of the lattice 106. In other words, the lattice interval C may be, for example, λ/2n, where λ is the period of an apparent lateral wave of a desired oscillation mode, and n is a mean refractive index of the periodic structure. Therefore, the diameter B of the region wherein light confinement takes place can be 3λ/2n. In other words, the lattices 106-109 are composed of absorbent material such that, by placing the lattice 107 at a position of a node of the desired oscillation mode, optical loss can be added to modes other than the desired oscillation mode without disturbing the desired oscillation mode.

It is noted that the SES laser 100 may further include one or more lattices between the lattice 106 and the lattice 107, wherein the one or more lattices may be inserted at nodal positions of the desired oscillation mode, and the lattice intervals may preferably be equal to one another to form the diffraction grating, which may be, for example, λ/2 without being limited this value. Also, in the diffraction grating 110, the gap between the lattice 107 and the lattice 108 and the gap D between the lattice 108 and the lattice 109 may be, for example, λ/4n. As a result, the refracted light can be effectively reflected.

Furthermore, the lattices 106, 107, 108 and 109 and/or lattice between 106-107 and/or lattices between 107-108 may have a symmetrical cross-sectional shape, such as, for example, a cylindrical shape, but also an asymmetrical cross-sectional shape having a taper, such as, for example, a conical shape.

As a result of the structure described above, light confinement occurs inside the lattice 107, and the number of oscillation modes is determined by the light confining region. On the other hand, the current is confined by the current constricting section 105. Therefore, by enlarging the inner diameter A of the current constricting section 105, the amount of generation of Joule heat caused by the resistance can be reduced, and a localized temperature increase can be prevented, such that the amount of current at a rolloff point can be made greater, and a high power output can be obtained. Furthermore, as the current level reaching a rolloff point moves away from the driving current range due to the high power output, such that operations in a wider temperature range can be made possible. So, by enlarging the inner diameter A of the current constricting section 105 and at the same time reducing the diameter B of the light confining region 110, the number of oscillation modes can be reduced without greatly decreasing output power.

It is noted that the diameter B of the light confining region may be appropriately adjusted according to a desired number of modes, a designed wavelength and the like.

The SES laser 100 further includes a first electrode 114 and a second electrode 116. The first electrode 114 and the second electrode 116 are used to drive the SES laser 100.

More concretely, as shown in FIG. 1, the first electrode 114 is formed on a top surface of the second mirror 104. More specifically, the first electrode 114 is formed on the top surface of the third columnar section 140. The second electrode 116 is formed on a back surface of the semiconductor substrate 101. The first electrode 114 may have a plane configuration that is in a ring shape, for example, as shown in FIG. 2. Also, the first electrode 114 may have a linear lead-out section that is lead out from the ring shaped section that is in contact with the top surface of the second mirror 104.

Because the first electrode 114 is provided near the active layer 103 in a manner described above, the distance in which current flows through the second mirror 104 can be made shorter. As a result, the resistance can be lowered, and heat generation can be reduced. It is noted that, in the present embodiment, the second electrode 116 is provided on the back surface of the semiconductor substrate 101, but may be provided on a upper side surface of the first mirror 102.

The second electrode 116 may be composed of, for example, a laminated film of an alloy of gold (Au) and germanium (Ge), and gold (Au). Also, the first electrode 114 may be composed of, for example, a laminated film of platinum (Pt), titanium (Ti) and gold (Au). Electrical current is injected in the active layer 103 by the first electrode 114 and the second electrode 116. It is noted that the materials for forming the first electrode 114 and the second electrode 116 are not limited to those described above, and other materials, such as, for example, an alloy of gold (Au) and zinc (Zn) can be used. The SES laser 100 defines an emission surface inside the first electrode 114 and can emit light upwardly from the inside of the first electrode 114.

It is noted that the SES laser 100 in accordance with the present embodiment may further have one or more diffraction gratings around the diffraction grating 110 described above. The gap between lattices composing the diffraction grating may be the same as or different from that of the diffraction grating 110 described above.

### 2. Method For Manufacturing SES Laser

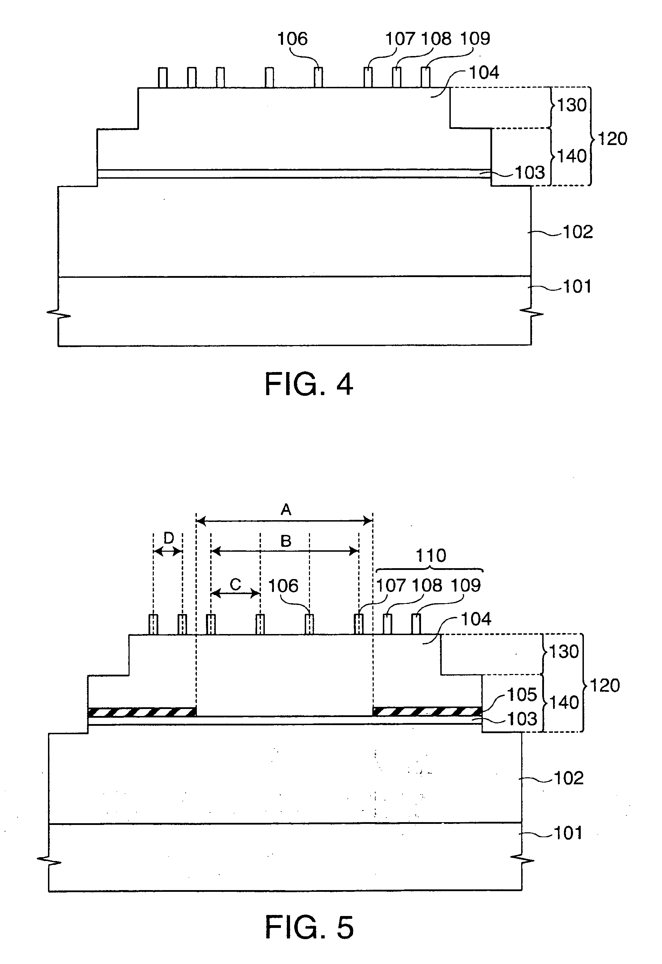

Next, an example of a method for manufacturing the SES laser 100 in accordance with an embodiment of the invention is described with reference to FIG. 3 through FIG. 5. FIG. 3 through FIG. 5 are cross-sectional views schematically showing a process for manufacturing the SES laser 100 shown in FIG. 1 and FIG. 2, and correspond to the cross-sectional view shown in FIG. 1, respectively.
(1) First, on a surface of a substrate 101 composed of an n-type GaAs layer, a semiconductor multilayer film is formed by epitaxial growth while modifying its composition, as shown in FIG. 3. It is noted here that the semiconductor multilayer film may be formed from, for example, a first mirror 102a of alternately laminated n-type Al_{0.9}Ga_{0.1}As layers and n-type Al_{0.1} Ga_{0.9}As layers, an active layer 103a composed of GaAs well layers and Al_{0.3}Ga_{0.7}As barrier layers in which the well layers include a quantum well structure composed of three layers, a second mirror 104a of alternately laminated p-type Al_{0.9}Ga_{0.1}As layers and p-type Al_{0.1}Ga_{0.9}As layers, and a photoabsorption layer 106a including a p-type GaAs layer. However, when the absorption effect does not need to be used for controlling higher modes, an absorption material may not necessarily be used.
   The temperature at which the epitaxial growth is conducted is appropriately decided depending on the growth method, the kind of raw materials, the type of the substrate 101, and the kind, thickness and carrier density of the semiconductor multilayer film to be formed, and in general, for example in the case of MOCVD, may preferably be 450°C - 800°C. Also, the time required for conducting the epitaxial growth is appropriately decided just like the temperature. Furthermore, a metal-organic vapor phase growth (MOVPE: metal-organic vapor phase epitaxy) method, a molecular beam epitaxy (MBE) method or a liquid phase epitaxy (LPE) method can be used as a method for the epitaxial growth.
(2) Then, the first mirror 102a, the active layer 103a, the second mirror 104a and the photoabsorption layer 106a are patterned in a desired configuration by using a known lithography technique and etching technique, thereby forming a first columnar section 120 (see FIG. 4). More concretely, the first mirror 102a, the active layer 103a, and a lower portion of the second mirror 104a are patterned to form a third columnar section 140, and then an upper portion of the second mirror 104a and the photoabsorption layer 106a are patterned to form a second columnar section 130.
   Furthermore, appropriate techniques including a photolithography technique, etching technique and electron beam processing technique are applied to the photoabsorption layer 106a, thereby forming a plurality of lattices 106, 107, 108 and 109.
3) Next, by placing the columnar section 120 in a water vapor atmosphere at about 400°C, for example, a layer having a high Al composition in the above-described second mirror 104 is oxidized from its side surface, whereby a current constricting section 105 is formed (see FIG. 5). In this step, the processing time, etc. are adjusted so that the inner diameter of the current constricting section 105 becomes greater than the diameter of the lattice 107.
   The oxidation rate depends on the furnace temperature, the amount of water vapor that is supplied, and the Al composition and the film thickness of the layer to be oxidized. In the SES laser 100 equipped with the current constricting section 105 that is formed by oxidation, electric current flows only in a portion that is not oxidized. Accordingly, by controlling the diameter of the oxide aperture to be formed in the step of forming the current constricting section 105 by oxidation, the current path can be controlled.
(4) Then, as shown in FIG. 1, a first electrode 114 and a second electrode 116 are formed. Prior to forming each of the electrodes, areas where the electrodes are to be formed may be washed by using a plasma treatment method or the like depending on the requirements. As a result, a device with more stable characteristics can be formed.

Then, photoresist is provided in areas other than forming regions where the first electrode 114 and the second electrode 116 are to be formed, and a single layer film or a multilayer film (not shown) of conductive material for electrodes is formed by, for example, a vacuum deposition method. Then portions of the multilayered film other than specified positions (in areas where the photoresist remains) are removed by a known lift-off method, whereby the electrodes are formed in desired regions.

Next, an annealing treatment is conducted in, for example, a nitrogen atmosphere according to the requirements. The temperature of the annealing treatment may be, for example, about 400°C. The annealing treatment may be conducted for, for example, about 3 minutes.

The process described above may be conducted for each of the electrodes, or a plurality of electrodes may be formed at the same time. It is noted that the second electrode 116 may be composed of, for example, a laminated film of an alloy of gold (Au) and germanium (Ge), and gold (Au). The first electrode 114 may be composed of, for example, a laminated film of platinum (Pt), titanium (Ti) and gold (Au). It is noted that the materials of the electrodes are not limited to those described above, and other known metal, alloy and laminated films of the aforementioned materials may be used.

By the process described above, the SES laser 100 in accordance with the present embodiment shown in FIG. 1 and FIG. 2 is obtained.

### 3. Modified Examples

Next, modified examples in accordance with the present embodiment are described with reference to the accompanying drawings.

### 3.1. First Modified Example

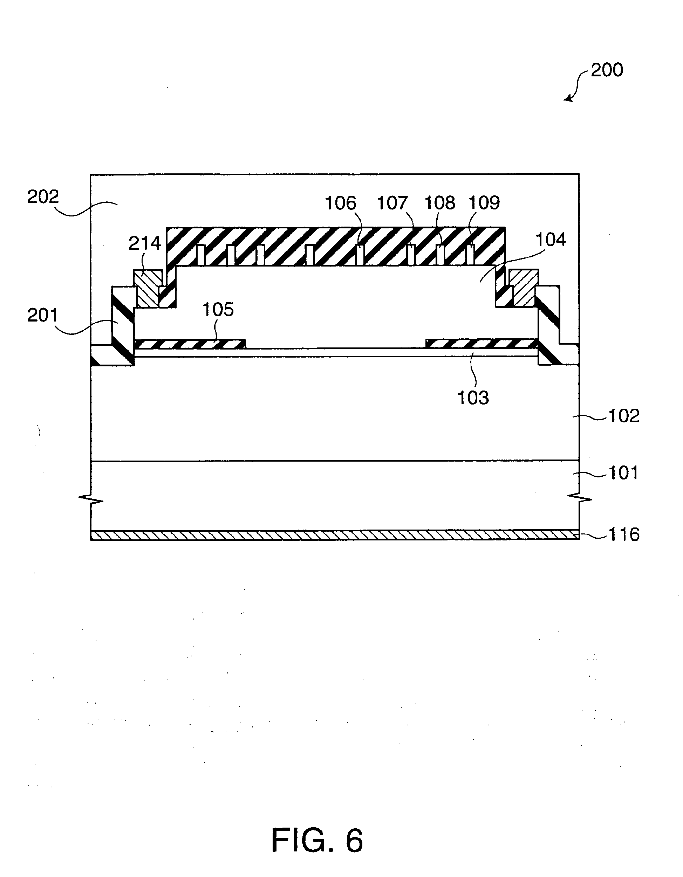

FIG. 6 is a schematic cross-sectional view of an SES laser 200 in accordance with a first modified example. The SES laser 200 in accordance with the first modified example is different from the SES laser 100 of the above-described embodiment in that the SES laser 200 is further equipped with a transparent insulation (or dielectric) film 201 and a heat radiation film 202. The transparent insulation film 201 transmits light emitted from the SES laser 200 and is composed of insulation material. The transparent insulation film 201 may be composed of, for example, a silicon nitride (SiN) thin film. The silicon nitride thin film not only has light transmittivity and insulating property, but is also excellent in oxidation resisting property, such that the silicon nitride thin film can prevent oxidation and deterioration of the SES laser 200.

The heat radiation film 202 transmits light emitted from the SES laser 200, and is composed of a material having a high thermal conductivity. The heat radiation film 202 transmits light at least in a region above an emission surface of the SES laser 200, and is composed of a material having a high thermal conductivity. The heat radiation film 202 may be composed of, for example, silicon carbide (SiC), diamond (diamond-like-carbon), or sapphire.

The transparent insulation film 201 and the heat radiation film 202 are composed of materials that transmit light emitted from the SES laser 200, such that the SES laser 200 can emit laser light upwardly. Also, the SES laser 200 has an improved heat radiation efficiency because it is equipped with the transparent insulation film 201 and the heat radiation film 202. As a result of the above, an elevation of the device temperature by injection current can be suppressed.

Next, an example of a method for manufacturing the SES laser 200 is described. The steps (1) - (3) for manufacturing the SES laser 100 in accordance with the embodiment described above are conducted, and then a transparent insulation film 201 is formed. The transparent insulation film 201 is formed and patterned by known methods. For forming a silicon nitride thin film as the transparent insulation film 201, a plasma CVD (Chemical Vapor Deposition) method may be used.

Next, a first electrode 214 and a second electrode 116 are formed by the method described above, and a heat radiation film 202 is formed. As the heat radiation film 202, silicon carbide, diamond, sapphire or the like can be used, as described above. For example, a sputter method may be used as the film forming method of a silicon carbide or sapphire film. For example, a CVD method, a sputter method or a thermoelectron impact method may be used as the film forming method of a diamond like carbon film. Then, patterning may be conducted by etching or the like to thereby expose a lead-out section of the first electrode 214. Alternatively, a lead-out section of the first electrode 314 may be exposed by a lift-off method in which a resist layer is left in advance on an upper surface of the lead-out section, and the resist layer is removed after forming the film.

By the process described above, the SES laser 200 is manufactured. It is noted that other portions of the structure and manufacturing process for the SES laser 200 in accordance with the first modified example are generally the same as those of the structure and manufacturing process for the SES laser 100 in accordance with the embodiment described above, and therefore their description is omitted.

### 3.2. Second Modified Example

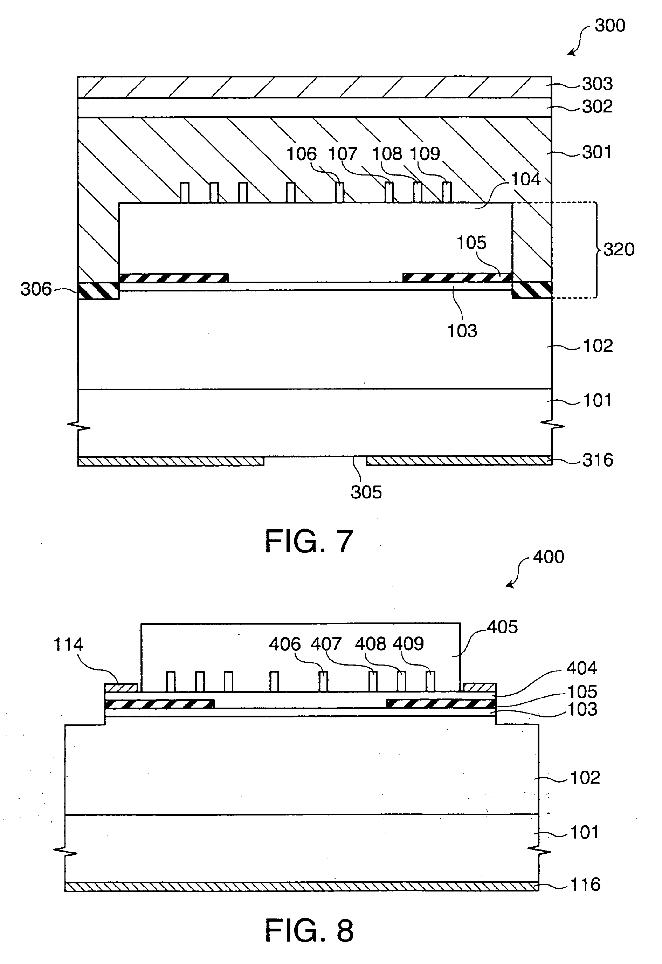

FIG. 7 is a schematic cross-sectional view of an SES laser 300 in accordance with a second modified example that is currently not claimed but useful for understanding the invention. The SES laser 300 in accordance with the second modified example is different from the SES laser 100 of the above-described embodiment in that the SES laser 300 is further equipped with a conductive film 301, a first heat radiation film 302, a second heat radiation film 303 and an insulation film 306, and does not have a first electrode 114. The SES laser 300 in accordance with the second modified example has a laser light emission surface 305 in its lower side, and is therefore different from the SES laser 100 of the above-described embodiment that has an emission surface in its upper side.

The conductive film 301 is composed of a conductive material, such as, for example, gold-tin (AuSn) and the like, and can function as an electrode for driving the SES laser 300. The conductive film 301 is formed in a manner to cover the first columnar section 320, and is in contact with the top surface of the second mirror 104.

The first heat radiation film 302 is formed above the conductive film 301. The first heat radiation film 302 is composed of a material having a high thermal conductivity. The first heat radiation film 302 may be composed of, for example, silicon carbide (SiC), diamond (diamond-like-carbon), sapphire or the like. The second heat radiation film 303 is formed above the first heat radiation film 302. The second heat radiation film 303 is composed of a material having a high thermal conductivity. When the second heat radiation film 303 is composed of a conductive material such as copper, the second heat radiation film 303 can function as a wiring when it is electrically connected to the conductive film 301. The insulation film 306 is formed in a manner to cover a part of the circumference of the second mirror 104, the current constricting section 105 and the active layer 103, and the top surface of the first mirror 102.

The semiconductor substrate 101 may be composed of a transparent substrate that transmits light emitted from the SES laser 300. On the other hand, when the substrate used is not transparent, an etching stopper layer may be provided on the substrate 101 before the first mirror 102a is laminated, and an emission aperture may be provided by etching conducted from the back surface side. A second electrode 316 is formed on the back surface of the semiconductor substrate 101, and has an emission surface 305 in a region surrounded by the second electrode 316. By this, the SES laser 300 can emit laser light downwardly.

Next, an example of a method for manufacturing the SES laser 300 is described. First, the steps (1) - (3) for manufacturing the SES laser 100 in accordance with the embodiment described above are conducted, and then an insulation film 306 and a second electrode 316 are formed. The material of the insulation film 306 is not particularly limited, but can be composed of, for example, a silicon nitride thin film. The silicon nitride thin film may be formed by the method described above.

Next, after forming a first heat radiation film 302 on a second heat radiation film 303, a conductive film 301 such as a solder film is coated on the first heat radiation film 302. Then, the first mirror 102, the active layer 103 and the second mirror 104 are embedded in the conductive film 301, and then the conductive film 301 is hardened.

By the process described above, the SES laser 300 is manufactured. In this manner, the SES laser 300 is equipped with the conductive film 301 that can function as an electrode and heat sink, which can contact the second mirror 104 in a wider area, whereby its heat radiation efficiency can be increased. By this, an elevation of the device temperature by injection current can be suppressed. Also, the SES laser 300 is equipped with the first heat radiation film 302 and the second heat radiation film 303 having high thermal conductivity, which can further increase the heat radiation efficiency.

It is noted that other portions of the structure and manufacturing process for the SES laser 300 in accordance with the second modified example are generally the same as those of the structure and manufacturing process for the SES laser 100 in accordance with the embodiment described above, and therefore their description is omitted.

### 3.3. Third Modified Example

FIG. 8 is a schematic cross-sectional view of an SES laser 400 in accordance with a third modified example. The SES laser 400 in accordance with the third modified example is different from the SES laser 100 of the above-described embodiment in that the SES laser 400 is further equipped with a dielectric layer 405 above a second mirror 404. The dielectric layer 405 may be composed of alternately laminated layers having different refractive indexes, and can function as a mirror. The dielectric layer 405 has a plane configuration that is in, for example, a circular shape having a smaller diameter than that of the second mirror 404, but may not be limited to this particular embodiment. Furthermore, a plurality of lattices 406, 407, 408 and 409 are formed on the top surface of the second mirror 404. In this case, a portion of the dielectric layer 405 may extend into gaps among the lattices 406, 407, 408 and 409 and to the outside thereof. Lattices 406, 407, 408 and 409 may be formed with the dielectric layer.

Furthermore, by forming the dielectric layer 405 that can function as a mirror above the second mirror 404, the film thickness of the second mirror 404 can be made smaller. As a result, the lattices 406, 407, 408 and 409 can be formed closer to the active layer 103, such that the oscillation mode can be more effectively controlled. It is noted that the SES laser 400 in accordance with the third embodiment may not need to include the second mirror 404. In this case, the dielectric layer 405 alone can function as an upper mirror.

Also, a first electrode 114 is formed on the top surface of the second mirror 404. The first electrode 114 may be formed around the dielectric layer 405. In the SES laser 400 in accordance with the third modified example, the film thickness of the second mirror 404 can be made smaller, as described above. As a result, the first electrode 114 can be formed closer to the active layer 103, and heat generated by the current flowing through the second mirror 404 can be reduced.

The dielectric layer 405 may be formed with Ta₂O₃, TiO₂, Ti₂O₅, Ti, Si, SiO₂, SiN or the like, and may be composed of a film of alternately laminated SiO₂ and SiN layers. The dielectric layer 405 can be formed with Si and SiO₂. The dielectric layer 405 may be formed by, for example, plasma CVD, sputtering or the like.

When the mirror is provided using dielectric layers in a manner described above, the refractive index ratio among the layers can be made greater, and the number of pairs can be reduced, compared to the case where the mirror is formed without using dielectric layers. By this, the material resource can be reduced.

It is noted that the SES laser 400 may further have one or more diffraction gratings around the lattice 409 described above. In this case, portion of the dielectric layer 405 may extend not only into gaps between the lattices composing the diffraction grating but also into gaps between the grating 409 and the diffraction lattices around the lattice 409.

It is noted that other portions of the structure and manufacturing process for the SES laser 400 in accordance with the third modified example are generally the same as those of the structure and manufacturing process applied to the SES laser 100 in accordance with the embodiment described above, and therefore their description is omitted.

### 3.4. Fourth Modified Example

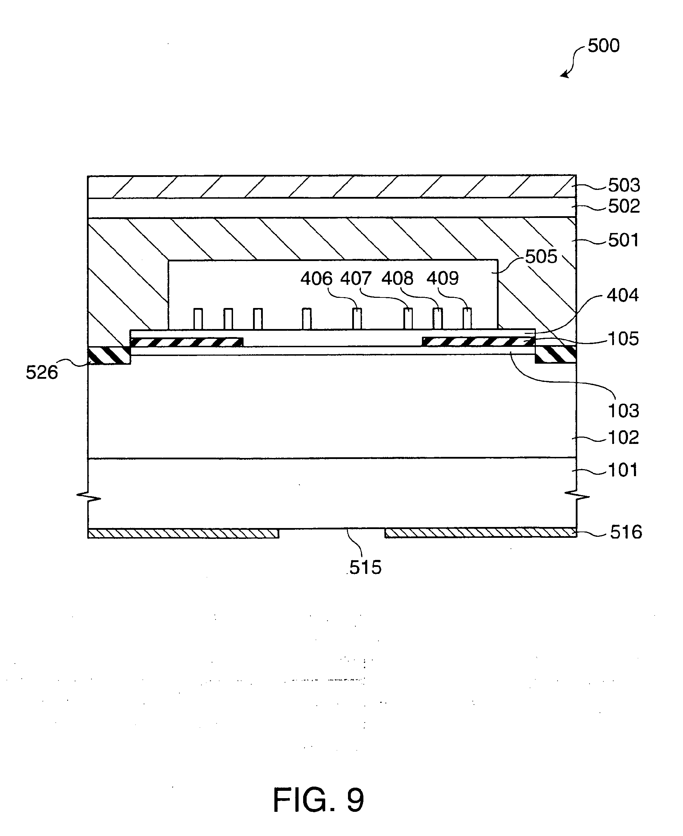

FIG. 9 is a schematic cross-sectional view of an SES laser 500 in accordance with a fourth modified example which is currently not claimed but useful for understanding the invention. The SES laser 500 in accordance with the fourth modified example is different from the SES laser 100 of the above-described embodiment in that the SES laser 500 is further equipped with a dielectric layer 505, a conductive film 501, a first heat radiation film 502, a second heat radiation film 503 and an insulation film 526, and does not have a first electrode 114. The SES laser 500 in accordance with the fourth modified example has a laser light emission surface 515 in its lower side, and is therefore different from the SES laser 100 of the above-described embodiment that has an emission surface in its upper side.

The conductive film 501 is composed of a conductive material, such as, for example, gold-tin (AuSn) and the like, and can function as an electrode for driving the SES laser 500. The conductive film 501 is formed in a manner to cover the dielectric layer 505, and is in contact with the top surface of the second mirror 404.

The first heat radiation film 502 is formed above the conductive film 501. The first heat radiation film 502 is composed of a material having a high thermal conductivity. The first heat radiation film 502 may be composed of, for example, silicon carbide (SiC), diamond (diamond-like-carbon), sapphire or the like. The second heat radiation film 503 is formed above the first heat radiation film 502. The second heat radiation film 503 is composed of a material having a high thermal conductivity. When the second heat radiation film 503 is composed of a conductive material such as copper, the second heat radiation film 503 can function as a wiring when it is electrically connected to the conductive film 501. The insulation film 526 is formed in a manner to cover the circumference of the second mirror 504, the current constricting section 105 and the active layer 103, and the top surface of the first mirror 102.

The semiconductor substrate 101 may be composed of a transparent substrate that transmits light emitted from the SES laser 500. On the other hand, when the substrate used is not transparent, an etching stopper layer may be provided on the substrate 101 before the first mirror 102a is laminated, and an emission aperture may be provided by etching conducted from the back surface side. A second electrode 516 is formed on the back surface of the semiconductor substrate 101, and has an emission surface 515 in a region surrounded by the second electrode 516. By this, the SES laser 500 can emit laser light downwardly.

Next, an example of a method for manufacturing the SES laser 500 is described. First, the steps (1) - (3) for manufacturing the SES laser 100 in accordance with the embodiment described above are conducted, and then a dielectric layer 505 is formed by the method described above. Next, a second electrode 516 is formed, and then an insulation film 526 is formed. The material of the insulation film 526 is not particularly limited, but can be composed of, for example, a silicon nitride thin film. The silicon nitride thin film may be formed by the method described above.

Next, after forming a first heat radiation film 502 on a second heat radiation film 503, a conductive film 501 such as a solder film is coated on the first heat radiation film 502. Then, the first mirror 102, the active layer 103, the second mirror 404 and the dielectric layer 505 are embedded in the conductive film 501, and then the conductive film 501 is hardened.

By the process described above, the SES laser 500 is manufactured. In this manner, the SES laser 500 is equipped with the conductive film 501 that can function as an electrode and heat sink, which can contact the second mirror 404 and the dielectric layer 505 in a wider area, whereby its heat radiation efficiency can be increased. Furthermore the total thickness of the SES laser 500 is smaller than that of the SES laser 300, an elevation of the device temperature can be suppressed at the time of current injection. Also, the SES laser 500 is equipped with the first heat radiation film 502 and the second heat radiation film 503 having high thermal conductivity, which can further increase the heat radiation efficiency.

It is noted that other portions of the structure and manufacturing process for the SES laser 500 in accordance with the fourth modified example are generally the same as those of the structure and manufacturing process for the SES laser 100 in accordance with the embodiment described above, and therefore their description is omitted.

The invention is not limited to the embodiments described above, but its scope is defined by the claims. For example, a transparent insulation film 201 and a heat radiation film 202 in accordance with the first modified example may be provided above the SES laser 400 in accordance with the third modified example.

## Claims

1. A surface-emitting type semiconductor laser comprising:
a substrate (101);
a first electrode provided on one side of the substrate (101);
a first mirror (102) provided on another side of the substrate (101) opposite to said one side;
an active layer (103) formed above the first mirror (102);
a second mirror (104; 404; 504) formed above the active layer (103);
a current constricting section (105) formed above or below the active layer (103);
a light confining region formed inside a region surrounded by the current constricting section (105) as viewed in a plan view; and
a second electrode (114);
wherein a first columnar section (120) including at least the active layer (103), the second mirror (104) and the current constricting section (105) is divided into a second columnar section (130) and a third columnar section (140), the third columnar section (140) having the active layer (103), the current constricting section (105) and a lower part of the second mirror (104) and being formed below the second columnar section (130) having the remaining upper part of the second mirror, the third columnar section (140) being dimensioned to be larger in plan view than the second columnar section (130); and
said second electrode (114) is provided around the second columnar section (130) on a top surface of the third columnar section (140) at a step formed between the third and the second columnar section (140, 130),
**characterized in that**
the third columnar section (140) is dimensioned to be smaller in plan view than the substrate (101); and
the surface-emitting type semiconductor laser further comprises a plurality of mutually concentric circular rings (106, 107, 108, 109) composed of light-absorbing material;
a second ring (107) of the plurality of mutually concentric circular rings (106, 107, 108, 109) and rings (108, 109) lying outside the second ring (107) form a diffraction grating (110) that surrounds the light confining region and serves to maintain light confinement in the light confining region; and
the second ring (107) of the plurality of mutually concentric circular rings (106, 107, 108, 109) is positioned at a first nodal position of a desired oscillation mode of the surface-emitting type semiconductor laser radially outside an innermost first ring (106) of the plurality of mutually concentric circular rings (106, 107, 108, 109); and
at least one further ring is inserted at a further nodal position of the desired oscillation mode between the first ring (106) and the second ring (107);
such that optical loss is added to the modes other than the desired oscillation mode without disturbing the desired oscillation mode.

2. A surface-emitting type semiconductor laser according to claim 1, further comprising a heat radiation film (202; 302, 303; 502, 503) formed above the second mirror (104; 404).

3. A surface-emitting type semiconductor laser according to claim 2, wherein the heat radiation film (202) has optical transparency.

4. A surface-emitting type semiconductor laser according to claim 2, wherein the heat radiation film (202) is composed of a thermally conductive material, and further comprising an insulation layer (201) having optical transparency provided between the second mirror (104) and the heat radiation film (202).

5. A surface-emitting type semiconductor laser according to claim 1, further comprising an electrically conductive film (301; 501) formed on an entire surface above the second mirror (104; 504), a first heat radiation film (302; 502) formed above the conductive film (301; 501), and a second heat radiation film (303; 503) formed above the first heat radiation film (302; 502), wherein the conductive film (301; 501) functions as an electrode for driving the surface-emitting type semiconductor laser, and the second heat radiation film (303; 503) is composed of an electrically conductive material and is electrically connected to the conductive film (301; 501).

6. A surface-emitting type semiconductor laser according to claim 1, further comprising a dielectric mirror (405) formed above the second mirror (404), wherein the diffraction grating (110) is formed between the dielectric mirror (405) and the active layer (103).

7. A surface-emitting type semiconductor laser according to claim 6, wherein a plurality of diffraction gratings are arranged in a plane perpendicular to the light emission direction, and a part of the dielectric mirror is formed between rings of the diffraction gratings.

## Patentansprüche

1. Oberflächenemittierender Halbleiterlaser, umfassend:
ein Substrat (101);
eine erste Elektrode, die an einer Seite des Substrats (101) bereitgestellt ist;
einen ersten Spiegel (102), der an einer anderen Seite des Substrats (101) gegenüber der einen Seite bereitgestellt ist;
eine aktive Schicht (103), die über dem ersten Spiegel (102) ausgebildet ist;
einen zweiten Spiegel (104; 404; 504), der über der aktiven Schicht (103) ausgebildet ist;
einen Stromeinschnürungsabschnitt (105), der über oder unter der aktiven Schicht (103) ausgebildet ist;
eine lichteinschließende Zone, die innerhalb einer Zone ausgebildet ist, die vom Stromeinschnürungsabschnitt (105), wenn in einer Draufsicht betrachtet, umgeben ist; und
eine zweite Elektrode (114);
wobei ein erster säulenförmiger Abschnitt (120), der mindestens die aktive Schic
ht (103), den zweiten Spiegel (104) und den Stromeinschnürungsabschnitt (105) beinhaltet, in einen zweiten säulenförmigen Abschnitt (130) und einen dritten säulenförmigen Abschnitt (140) unterteilt ist, wobei der dritte säulenförmige Abschnitt (140) die aktive Schicht (103), den Stromeinschnürungsabschnitt (105) und einen unteren Teil des zweiten Spiegels (104) aufweist und unter dem zweiten säulenförmigen Abschnitt (130), aufweisend den übrigen oberen Teil des zweiten Spiegels, ausgebildet ist, wobei der dritte säulenförmige Abschnitt (140) so dimensioniert ist, dass er in der Draufsicht größer als der zweite säulenförmige Abschnitt (130) ist; und
die zweite Elektrode (114) um den zweiten säulenförmigen Abschnitt (130) herum auf einer oberen Oberfläche des dritten säulenförmigen Abschnitts (140) an einer Stufe bereitgestellt ist, die zwischen dem dritten und dem zweiten säulenförmigen Abschnitt (140, 130) ausgebildet ist,
**dadurch gekennzeichnet, dass**
der dritte säulenförmige Abschnitt (140) so dimensioniert ist, dass er in der Draufsicht kleiner als das Substrat (101) ist; und
der oberflächenemittierende Halbleiterlaser ferner eine Vielzahl von zueinander konzentrischen, kreisrunden Ringen (106, 107, 108, 109) umfasst, die aus lichtabsorbierendem Material bestehen;
ein zweiter Ring (107) der Vielzahl von zueinander konzentrischen, kreisrunden Ringen (106, 107, 108, 109) und Ringe (108, 109), die außerhalb des zweiten Rings (107) liegen, ein Beugungsgitter (110) bilden, das die lichteinschließende Zone umgibt und dazu dient, den Lichteinschluss in der lichteinschließenden Zone aufrecht zu halten;
und '
der zweite Ring (107) der Vielzahl von zueinander konzentrischen, kreisrunden Ringen (106, 107, 108, 109) in einer ersten Knotenposition einer gewünschten Schwingungsart des oberflächenemittierenden Halbleiterlasers radial gesehen außerhalb eines innersten ersten Rings (106) der Vielzahl von zueinander konzentrischen, kreisrunden Ringen (106, 107, 108, 109) positioniert ist; und
mindestens ein weiterer Ring in einer weiteren Knotenposition der gewünschten Schwingungsart zwischen dem ersten Ring (106) und dem zweiten Ring (107) eingefügt ist;
sodass zu den Arten ein optischer Verlust anstelle der gewünschten Schwingungsart hinzugefügt wird, ohne die gewünschte Schwingungsart zu stören.

2. Oberflächenemittierender Halbleiterlaser nach Anspruch 1, ferner umfassend eine Wärmestrahlungsfolie (202; 302, 303; 502, 503), die über dem zweiten Spiegel (104; 404) ausgebildet ist.

3. Oberflächenemittierender Halbleiterlaser nach Anspruch 2, wobei die Wärmestrahlungsfolie (202) eine optische Transparenz aufweist.

4. Oberflächenemittierender Halbleiterlaser nach Anspruch 2, wobei die Wärmestrahlungsfolie (202) aus einem thermisch leitfähigen Material besteht, und ferner umfassend eine Isolationsschicht (201), aufweisend eine optische Transparenz, die zwischen dem zweiten Spiegel (104) und der Wärmestrahlungsfolie (202) bereitgestellt ist.

5. Oberflächenemittierender Halbleiterlaser nach Anspruch 1, ferner umfassend eine elektrisch leitfähige Folie (301; 501), die auf einer gesamten Oberfläche über dem zweiten Spiegel (104; 504) ausgebildet ist, eine erste Wärmestrahlungsfolie (302; 502), die über der leitfähigen Folie (301; 501) ausgebildet ist, und eine zweite Wärmestrahlungsfolie (303; 503), die über der ersten Wärmestrahlungsfolie (302; 502) ausgebildet ist, wobei die leitfähige Folie (301; 501) als eine Elektrode zum Antrieb des oberflächenemittierenden Halbleiterlasers fungiert, und die zweite Wärmestrahlungsfolie (303; 503) aus einem elektrisch leitfähigen Material besteht und elektrisch mit der leitfähigen Folie (301; 501) verbunden ist.

6. Oberflächenemittierender Halbleiterlaser nach Anspruch 1, ferner umfassend einen dielektrischen Spiegel (405), der über dem zweiten Spiegel (404) ausgebildet ist, wobei das Beugungsgitter (110) zwischen dem dielektrischen Spiegel (405) und der aktiven Schicht (103) ausgebildet ist.

7. Oberflächenemittierender Halbleiterlaser nach Anspruch 6, wobei eine Vielzahl von Beugungsgittern in einer Ebene angeordnet ist, die lotrecht zur Lichtemittierungsrichtung ist, und ein Teil es dielektrischen Spiegels zwischen Ringen der Beugungsgitter ausgebildet ist.

## Revendications

1. Laser semi-conducteur à émission par la surface comprenant :
un substrat (101) ;
une première électrode prévue sur un côté du substrat (101) ;
un premier miroir (102) prévu sur un autre côté du substrat (101) en face dudit côté ;
une couche active (103) formée au-dessus du premier miroir (102) ;
un deuxième miroir (104 ; 404 ; 504) formé au-dessus de la couche active (103) ;
une section de limitation de courant (105) formée au-dessus ou en dessous de la couche active (103) ;
une zone de confinement de la lumière formée à l'intérieur d'une zone entourée de la section de limitation de courant (105) comme cela est représenté dans une vue en plan ; et
une deuxième électrode (114) ;
dans lequel une première section en colonne (120) comprenant au moins la couche active (103), le deuxième miroir (104) et la section de limitation de courant (105) est divisée en une deuxième section en colonne (130) et une troisième section en colonne (140), la troisième section en colonne (140) présentant la couche active (103), la section de limitation de courant (105) et une partie inférieure du deuxième miroir (104) et étant formée en dessous de la deuxième section en colonne (130) présentant la partie supérieure restante du deuxième miroir, la troisième section en colonne (140) étant dimensionnée de façon à être plus grande en vue en plan que la deuxième section en colonne (130) ; et
ladite deuxième électrode (114) est prévue autour de la deuxième section en colonne (130) sur une surface supérieure de la troisième section en colonne (140) au niveau d'un épaulement formé entre la troisième et la deuxième section en colonne (140, 130),
**caractérisé en ce que**
la troisième section en colonne (140) est dimensionnée pour être plus petite en vue en plan que le substrat (101) ; et
le laser semi-conducteur à émission par la surface comprend en outre une pluralité d'anneaux circulaires mutuellement concentriques (106, 107, 108, 109) composés de matériau absorbant la lumière ;
un deuxième anneau (107) parmi la pluralité d'anneaux circulaires mutuellement concentriques (106, 107, 108, 109) et des anneaux (108, 109) disposés à l'extérieur du deuxième anneau (107) forment un réseau de diffraction (110) qui entoure la zone de confinement de la lumière et permet d'assurer le confinement de la lumière dans la zone de confinement de la lumière ; et
le deuxième anneau (107) parmi la pluralité d'anneaux circulaires mutuellement concentriques (106, 107, 108, 109) est positionné au niveau d'une première position nodale d'un mode d'oscillation souhaité du laser semi-conducteur à émission par la surface radialement à l'extérieur d'un premier anneau le plus à l'intérieur (106) parmi la pluralité d'anneaux circulaires mutuellement concentriques (106, 107, 108, 109) ; et
au moins un autre anneau est inséré au niveau d'une autre position nodale du mode d'oscillation souhaité entre le premier anneau (106) et le deuxième anneau (107) ;
de sorte que l'affaiblissement optique soit ajouté aux modes autres que le mode d'oscillation souhaité sans perturber le mode d'oscillation souhaité.

2. Laser semi-conducteur à émission par la surface selon la revendication 1, comprenant en outre un film de rayonnement thermique (202 ; 302, 303 ; 502, 503) formé au-dessus du deuxième miroir (104 ; 404).

3. Laser semi-conducteur à émission par la surface selon la revendication 2, dans lequel le film de rayonnement thermique (202) possède une transparence optique.

4. Laser semi-conducteur à émission par la surface selon la revendication 2, dans lequel le film de rayonnement thermique (202) est composé d'un matériau thermoconducteur, et comprenant en outre une couche d'isolation (201) possédant une transparence optique prévue entre le deuxième miroir (104) et le film de rayonnement thermique (202).

5. Laser semi-conducteur à émission par la surface selon la revendication 1, comprenant en outre un film électro-conducteur (301 ; 501) formé sur une surface entière au-dessus du deuxième miroir (104 ; 504), un premier film de rayonnement thermique (302 ; 502) formé au-dessus du film conducteur (301 ; 501), et un deuxième film de rayonnement thermique (303 ; 503) formé au-dessus du premier film de rayonnement thermique (302 ; 502), dans lequel le film conducteur (301 ; 501) fonctionne comme une électrode pour commander le laser semi-conducteur à émission par la surface, et le deuxième film de rayonnement thermique (303 ; 503) est composé d'un matériau électriquement conducteur et est relié électriquement au film conducteur (301 ; 501).

6. Laser semi-conducteur à émission par la surface selon la revendication 1, comprenant en outre un miroir diélectrique (405) formé au-dessus du deuxième miroir (404), dans lequel le réseau de diffraction (110) est formé entre le miroir diélectrique (405) et la couche active (103).

7. Laser semi-conducteur à émission par la surface selon la revendication 6, dans lequel une pluralité de réseaux de diffraction est disposée dans un plan perpendiculaire à la direction d'émission de la lumière, et une partie du miroir diélectrique est formée entre des anneaux des réseaux de diffraction.
